# EUROPÄISCHE PATENTANMELDUNG

(11) **EP 1 416 527 A1**
(43) Veröffentlichungstag der Anmeldung: **06.05.2004**
(21) Anmeldenummer: 02405909.9
(22) Anmeldetag: 23.10.2002
(51) Int. Cl.: H01L 21/3213

(54) **Verfahren zur Herstellung eines Stufenprofils aus einer Schichtfolge**

(71) Anmelder: ABB Schweiz AG, 5400 Baden (CH)
(72) Erfinder: Assal, Jérôme, 8004 Zürich (CH); Eicher, Simon, 8049 Zürich (CH); Nanser, Erich, 5600 Lenzburg (CH)
(74) Vertreter: ABB Patent Attorneys

(57) **Zusammenfassung**

Bei einem Verfahren zur Bildung eines Stufenprofils aus einer Schichtfolge (2) mit einem ersten Strukturierungsschritt, in welchem eine erste Schichtteilfolge (21) bis auf eine erste Restschichtteilfolge (211) entfernt wird, in einem zweiten Strukturierungsschritt, in welchem eine unter der ersten Schichtteilfolge (21) gelegene zweite Schichtteilfolge (22) mittels Ätzen mit einem zweiten Ätzmittel partiell entfernt wird, und einem dritten Strukturierungsschritt, in welchem eine unter der zweiten Schichtteilfolge (22) gelegene dritte Schichtteilfolge (23) mittels Ätzen mit einem dritten Ätzmittel partiell entfernt wird, wird erfindungsgemäss im zweiten Strukturierungsschritt ein unter der ersten Restschichtteilfolge (211) liegender Bereich der zweiten Schichtteilfolge (22) und im dritten Strukturierungsschritt der erste Vorsprung der ersten Restschichtteilfolge (211) entfernt.

## Beschreibung

### Technisches Gebiet

Die vorliegende Erfindung bezieht sich auf das Gebiet der Halbleiterprozesstechnik. Sie betrifft ein Verfahren zur Herstellung eines Stufenprofils aus einer Schichtfolge nach dem Oberbegriff des ersten Patentanspruches.

### Stand der Technik

Um eine Strukturierung von auf Halbleitern aufgebrachten metallischen Schichten vorzunehmen, wird in mehreren aufeinander folgenden Strukturierungsschritten meist eine Vielzahl bekannter Techniken eingesetzt. Häufig wird dabei zunächst ein Photolack als Schutzschicht auf eine metallische Schicht oder eine metallische Schichtfolge aufgebracht. Eine resultierende erste Photolack-Schicht wird anschliessend durch eine erste Belichtungsmaske hindurch belichtet. Anschliessend kann, je nach Beschaffenheit des Photolacks, entweder ein belichteter oder ein unbelichteter Bereich der Photolack-Schicht entfernt werden, so dass der unbelichtete oder der belichtete Bereich zurückbleibt.

In einem oder mehreren Strukturierungsschritten wird dann die metallische Schicht oder Schichtfolge geätzt. Verschiedene Ätzverfahren stehen dabei zur Verfügung: Ätzen in wässriger Lösung, Trockenätzen, reaktives Ionenätzen oder eine Kombination dieser Verfahren. Der verbliebene Bereich der Photolack-Schicht verhindert oder verzögert dabei ein Ätzen unter ihm liegender Regionen der metallischen Schicht oder Schichtfolge.

Dabei kann ein nicht unerheblicher Gesamtaufwand resultieren, insbesondere wenn eine komplexe Strukturierung vorgenommen werden muss und/oder eine Schichtfolge geätzt werden muss, die aus einer Vielzahl von Einzelschichten besteht. In solchen Fällen erhöht sich die Anzahl der notwendigen Strukturierungsschritte, wobei häufig für verschiedene Strukturierungsschritte unterschiedliche Ätzverfahren oder zumindest unterschiedliche Ätzmittel benötigt werden. Zum Teil müssen dabei auch zwischen zwei Strukturierungsschritten nochmals ein oder mehrere weitere Photolack-Schichten aufgebracht, durch weitere Belichtungsmasken hindurch belichtet und belichtete oder unbelichtete Bereiche der weiteren Photolack-Schichten entfernt werden.

Bei einer Verwendung mehrerer Masken wird der Gesamtprozess jedoch zunehmend ungenau, insbesondere aufgrund von Ausrichtungsproblemen bei einem Positionieren der Belichtungsmasken.

Ein Anwendungsbeispiel für die Strukturierung von Schichtfolgen ist eine Aufbringung von Elektroden auf Halbleiterchips, insbesondere für Halbleiterchips, die in druckkontaktierbaren Leistungshalbleitermodulen mit nicht hermetisch abgeschlossenem Modulgehäuse eingesetzt werden. Solche Halbleiterchips umfassen zur elektrischen Kontaktierung vorteilhaft eine Schichtfolge aus Ti, Ni und Ag, wobei eine Ti-Schicht am nächsten beim Halbleiterchip gelegen ist. Abhängig von einer internen Struktur des Halbleiterchips und einem Herstellungsprozess muss diese Schichtfolge an verschiedenen Stellen strukturiert werden, beispielsweise in einem Bereich zwischen einer Hauptelektrode und einer Gateelektrode. Typische Strukturgrössen sind dabei im Allgemeinen kleiner als 0.5mm.

Bei der Strukturierung der Ti/Ni/Ag-Schichtfolge mittels Ätzen ist darauf zu achten, dass sich keine unterätzten Bereiche ausbilden, da in solchen beim Herstellungsprozess oder einem Betrieb der Halbleiterchips sich Verschmutzungen und/oder Ablagerungen ausbilden können, die schwierig zu entfernen sind, aber ein Betriebsverhalten der Halbleiterchips negativ beeinflussen können oder gar zu deren Zerstörung führen können.

### Darstellung der Erfindung

Es ist somit Aufgabe der Erfindung, ein Verfahren der eingangs genannten Art anzugeben, welches mit möglichst wenigen Strukturierungsschritten auskommt, wobei zwischen den Strukturierungsschritten kein Aufbringen von Schutzschichten erforderlich ist.

Diese und weitere Aufgaben werden durch ein Verfahren zur Bildung eines Stufenprofils aus einer Schichtfolge mit den Merkmalen des unabhängigen Patentanspruchs gelöst. Dabei wird in einem ersten, zweiten bzw. dritten Strukturierungsschritt eine erste, zweite bzw. dritte Schichtteilfolge jeweils partiell, d.h. bis auf eine erste, zweite bzw. dritte Restschichtteilfolge, entfernt. Im zweiten bzw. dritten Strukturierungsschritt geschieht dies unter Einwirkung eines zweiten bzw. dritten Ätzmittels. Erfindungsgemäss wird dabei im zweiten Strukturierungsschritt die erste Restschichtteilfolge unterätzt, d.h. ein unter ihr liegender Bereich der zweiten Schichtteilfolge wird entfernt. Ein dabei sich bildender erster Vorsprung der ersten Restschichtteilfolge wird im dritten Strukturierungsschritt wieder entfernt, um das gewünschte Stufenprofil zu erhalten.

In einer bevorzugten Variante des Verfahrens wird dabei im ersten Strukturierungsschritt ein erstes Ätzmittel verwendet, welches vorzugsweise dem im dritten Strukturierungsschritt verwendeten dritten Ätzmittel chemisch im wesentlichen identisch ist. Vorteilhaft kann dabei für den ersten und dritten Strukturierungsschritt ein identisches Ätzbad verwendet werden, was die Komplexität des Verfahrens weiter reduziert und eine wirtschaftlichere und umweltfreundlichere Durchführung des Verfahrens erlaubt.

Weitere vorteilhafte Ausgestaltungen der Erfindung sind in den abhängigen Ansprüchen angegeben, wobei Vorteile und Merkmale aus der nachfolgenden detaillierten Beschreibung bevorzugter Varianten der Erfindung in Verbindung mit der Zeichnung offensichtlich werden.

### Kurze Beschreibung der Zeichnungen

Fig. 1 zeigt ein Ausgangsprodukt für das erfindungsgemässe Verfahren.

Fig. 2 zeigt ein aus dem ersten Strukturierungsschritt resultierendes erstes Zwischenprodukt.

Fig. 3 zeigt ein aus dem zweiten Strukturierungsschritt resultierendes zweites Zwischenprodukt.

Fig. 4 zeigt ein aus dem dritten Strukturierungsschritt resultierendes Endprodukt.

Fig. 5 zeigt einen Halbleiterchip mit einem nach dem erfindungsgemässen Verfahren gebildeten Stufenprofil nach Entfernen einer Photolack-Schicht.

Die in den Zeichnungen verwendeten Bezugszeichen und deren Bedeutung sind in der Bezugszeichenliste zusammengefasst. Grundsätzlich bezeichnen gleiche Bezugszeichen gleiche Teile.

### Wege zur Ausführung der Erfindung

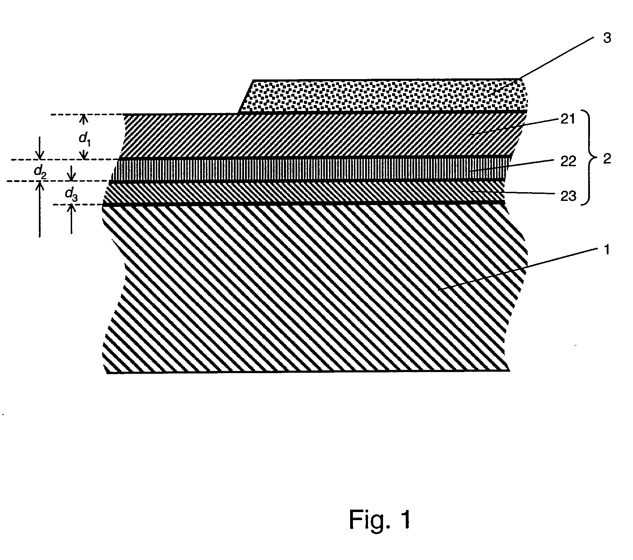

Fig. 1 zeigt ein Ausgangsprodukt für das erfindungsgemässe Verfahren, umfassend eine auf einem Halbleiterchip 1 aufgebrachte Schichtfolge 2 aus einer Ag-Schicht 21 als erster Schichtteilfolge, einer Ni-Schicht 22 als zweiter Schichtteilfolge und einer Ti-Schicht 23 als dritter Schichtteilfolge. Eine erste Dicke *d*₁ der Ag-Schicht 21 beträgt vorzugsweise einige Mikrometer, eine zweite Dicke *d*₂ der Ni-Schicht 22 und eine dritte Dicke *d*₃ der Ti-Schicht 23 betragen vorzugsweise je einige Zehntel Mikrometer. Ein Teil der Ag-Schicht 21 ist von einer Photolack-Schicht 3 als Schutzschicht bedeckt.

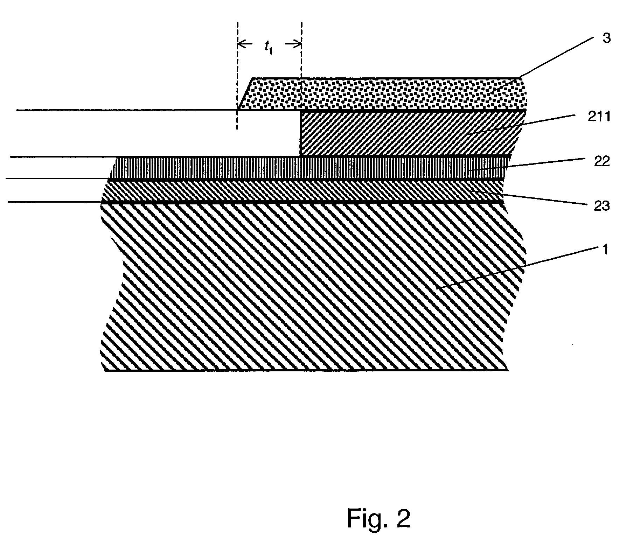

Um ein Stufenprofil in der Schichtfolge 2 zu bilden, wird zunächst in einem ersten Strukturierungsschritt die Ag-Schicht 21 mit einer chemischen Lösung aus Wasserstoffperoxid (H₂O₂), Ammoniumhydroxid (NH₄OH) und Wasser (H₂O) als erstem Ätzmittel geätzt. Vorzugsweise wird als erstes Ätzmittel eine Lösung verwendet, in welcher H₂O₂, NH₄OH, und H₂O in einem Volumenverhältnis von H₂O₂:NH₄OH:H:₂O = 1:*x*:*y* vorliegen, wobei vorzugsweise 0.5 < *x* < 2.0 und 4.0 < *y* < 10.0 gewählt wird. Vorzugsweise erfolgt der erste Strukturierungsschritt in bei einer Temperatur *T*₁, vorzugsweise mit 10°C < *T*₁ < 30°C, während einer Zeit von einigen Minuten bis wenigen zehn Minuten, vorteilhaft in einem ersten Ätzbad. Vorzugsweise wird dabei die Photolackschicht 3 unterätzt, so dass ein zweiter Vorsprung in der Photolackschicht 3 entsteht, der eine Tiefe *t*₁ aufweist, wobei vorzugsweise so weit unterätzt wird, dass *t*₁ > *d*₁ wird. Auf diese Weise wird gewährleistet, dass die Ag-Schicht 21 dort, wo sie nicht von Photolack bedeckt ist, vollständig und rückstandsfrei entfernt wird. Die Ni-Schicht 22 wird dabei im ersten Strukturierungsschritt im wesentlichen nicht angegriffen. Ein aus dem ersten Strukturierungsschritt resultierendes erstes Zwischenprodukt mit einer Ag-Restschicht 211 als erster Restschichtteilfolge ist in Fig. 2 zu sehen.

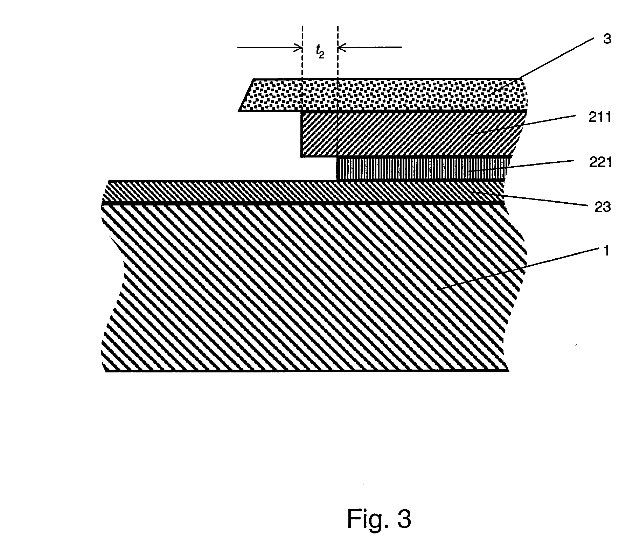

In einem zweiten Strukturierungsschritt wird, ausgehend vom ersten Zwischenprodukt aus Fig. 3, die Ni-Schicht 22 mit einer wässrigen Lösung von Salpetersäure (HNO₃) als zweitem Ätzmittel geätzt, so dass nur eine Ni-Restschicht 221 verbleibt. Für das Volumenverhältnis von HNO₃:H₂O = 1:z wird vorzugsweise 2.0 < *z* < 8.0 gewählt. Der zweite Strukturierungsschritt erfolgt bei einer Temperatur *T*₂, vorzugsweise mit 30°C < *T*₂ < 50°C, vorzugsweise während weniger zehn Minuten. Dabei wird ein unter der Ag-Restschicht 211 liegender Bereich der Ni-Schicht 22 entfernt, so dass ein erster Vorsprung der Ag-Restschicht 211 entsteht, der eine Tiefe *t*₂ aufweist. Ein nach dem zweiten Strukturierungsschritt resultierendes zweites Zwischenprodukt ist in Fig. 3 zu sehen.

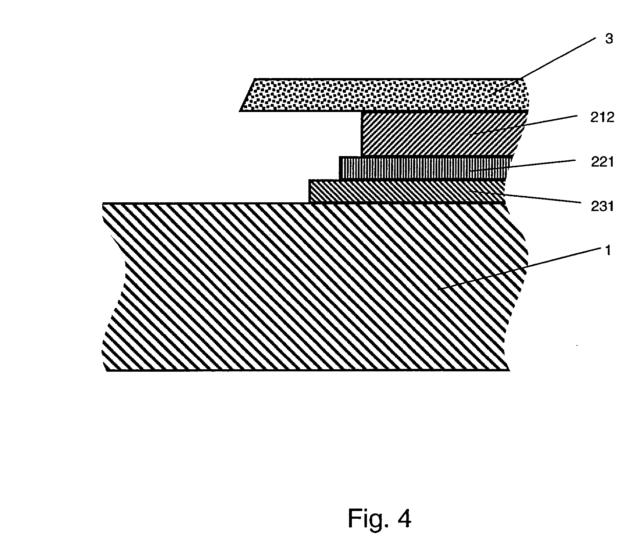

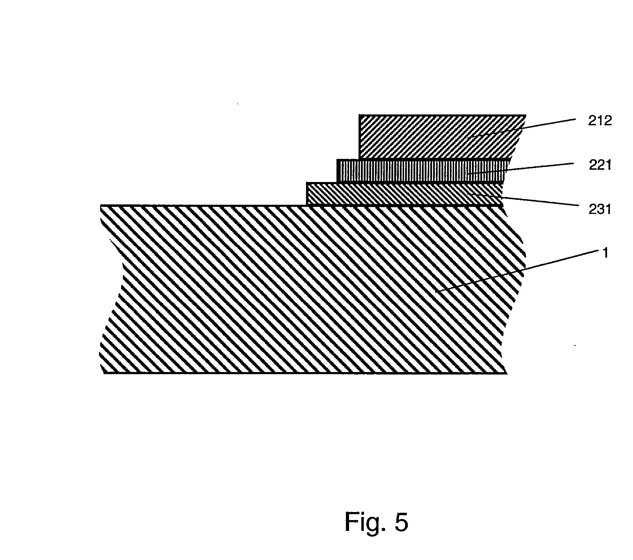

In einem dritten Strukturierungsschritt wird, ausgehend vom zweiten Zwischenprodukt aus Fig. 2, die Ti-Schicht 23 geätzt. Als drittes Ätzmittel wird dabei wiederum eine chemische Lösung aus Wasserstoffperoxid (H₂O₂), Ammoniumhydroxid (NH₄OH) und Wasser (H₂O) verwendet, die vorzugsweise im gleichen Volumenverhältnis vorliegen wie im ersten Ätzmittel. Vorteilhaft kann der dritte Strukturierungsschritt im ersten Ätzbad erfolgen. Die Ag-Restschicht 211 wird dabei gleichzeitig mit der Ti-Schicht zu einer Ag-Endschicht 212 geätzt, so dass der erste Vorsprung aufgelöst wird, die Ni-Schicht 22 überätzt wird, und sich schliesslich das gewünschte Stufenprofil ausbildet. Dabei wirkt zunächst der erste Vorsprung als eine chemische Maske, welche verhindert, dass ein unter dem ersten Vorsprung liegender Bereich der Ti-Schicht 22 durch das dritte Ätzmittel aufgelöst wird oder welche ein solches Auflösen zumindest stark verlangsamt. Nachdem der erste Vorsprung aufgelöst wurde, wirkt die Ni-Restschicht 221, die vom dritten Ätzmittel nicht angegriffen wird, als herkömmliche Maske für die Ti-Schicht 23. Da Ti vom dritten Ätzmittel signifikant langsamer geätzt wird als Ag, wird ein Unterätzen, d.h. einen Ausbildung eines dritten Vorsprungs der Ni-Restschicht 221, wirkungsvoll verhindert. Fig. 4 zeigt ein aus dem dritten Strukturierungsschritt resultierendes drittes Zwischenprodukt des erfindungsgemässen Verfahrens. Vorteilhaft wird schliesslich noch die Photolackschicht 3 entfernt, so dass der in Fig. 5 zu sehende Halbleiterchip 1 mit einem nach dem erfindungsgemässen Verfahren gebildeten Stufenprofil entsteht.

Das erfindungsgemässe Verfahren kann auch dann vorteilhaft angewendet werden, wenn sich zwischen dem Halbleiterchip 1 und der Schichtfolge 2, in welcher das Stufenprofil gebildet werden soll, ein oder mehrere Zwischenschichten befinden.

Vorteilhaft können auch weitere Strukturierungsschritte vor, nach oder zwischen dem ersten, zweiten und dritten Strukturierungsschritt vorgenommen werden.

### Bezugszeichenliste

- 1: Halbleiterchip
- 2: Schichtfolge
- 21: Ag-Schicht, erste Schichtteilfolge
- 22: Ni-Schicht, zweite Schichtteilfolge
- 23: Ti-Schicht, dritte Schichtteilfolge
- 211: Ag-Restschicht
- 212: Ag-Endschicht
- 221: Ni-Restschicht
- 3: Schutzschicht, Photolack-Schicht

## Patentansprüche

1. Verfahren zur Bildung eines Stufenprofils aus einer Schichtfolge (2), bei welchem
a) in einem ersten Strukturierungsschritt eine erste Schichtteilfolge (21) bis auf eine erste Restschichtteilfolge (211) entfernt wird,
b) in einem zweiten Strukturierungsschritt eine unter der ersten Schichtteilfolge (21) gelegene zweite Schichtteilfolge (22) mittels Ätzen mit einem zweiten Ätzmittel partiell entfernt wird,
c) in einem dritten Strukturierungsschritt eine unter der zweiten Schichtteilfolge (22) gelegene dritte Schichtteilfolge (23) mittels Ätzen mit einem dritten Ätzmittel partiell entfernt wird,
**dadurch gekennzeichnet, dass**
d) im zweiten Strukturierungsschritt ein unter der ersten Restschichtteilfolge (211) liegender Bereich der zweiten Schichtteilfolge (22) entfernt wird,
e) im dritten Strukturierungsschritt der erste Vorsprung der ersten Restschichtteilfolge (211) entfernt wird.

2. Verfahren nach Anspruch 1, **dadurch gekennzeichnet, dass** der zweite und der dritte Strukturierungsschritt in wässriger Lösung erfolgen.

3. Verfahren nach einem der vorangehenden Ansprüche, **dadurch gekennzeichnet, dass** der erste Strukturierungsschritt mittels Ätzen mit einem ersten Ätzmittel durchgeführt wird.

4. Verfahren nach Anspruch 3, **dadurch gekennzeichnet, dass** für das erste Ätzmittel und für das dritte Ätzmittel eine im wesentlichen identische chemische Zusammensetzung gewählt wird.

5. Verfahren nach einem der vorangehenden Ansprüche, **dadurch gekennzeichnet, dass** im ersten Strukturierungsschritt die erste Schichtteilfolge (21) so weit entfernt wird, dass ein zweiter Vorsprung der Schutzschicht (3) entsteht, der eine Länge *t*₂ aufweist, die grösser ist als eine Dicke *d*₁ der erste Schichtteilfolge (21).

6. Verfahren nach einem der vorangehenden Ansprüche, **dadurch gekennzeichnet, dass** die erste Schichtteilfolge (21) im wesentlichen Ag, die zweite Schichtteilfolge (22) im wesentlichen Ni und die dritte Schichtteilfolge (23) im wesentlichen Ti umfasst.

7. Verfahren nach einem der vorangehenden Ansprüche, **dadurch gekennzeichnet, dass** als zweites Ätzmittel eine wässrige Lösung von Salpetersäure, vorzugsweise in einem Verdünnungsverhältnis von 1:*z* mit 2.0 < *z* < 8.0 verwendet wird.

8. Verfahren nach einem der vorangehenden Ansprüche, **dadurch gekennzeichnet, dass** als erstes und drittes Ätzmittel ein Gemisch aus Wasserstoffperoxid, Ammoniumhydroxid und Wasser, vorzugsweise in einem Volumenverhältnis von angenähert 1:*x*:*y*, verwendet wird, wobei 0.5 < *x* < 2.0 und 4.0 < *y* < 10.0 gewählt wird.

9. Verfahren nach einem der vorangehenden Ansprüche, **dadurch gekennzeichnet, dass** vor dem ersten Strukturierungsschritt eine Schutzschicht (3) auf der ersten Schichtteilfolge (21) vorgesehen wird.
